# EUROPEAN PATENT SPECIFICATION

(11) **EP 0 552 893 B1**
(45) Date of publication and mention of the grant of the patent: **06.12.1995**
(21) Application number: 93300251.1
(22) Date of filing: 15.01.1993
(51) Int. Cl.: H01L 21/768

(54) **Method for forming an aluminium contact**
Verfahren zur Herstellung eines Aluminiumkontakts
Procédé de fabrication d'un contact en aluminium

(30) Priority: 21.01.1992 US 824238
(43) Date of publication of application: 28.07.1993
(73) Proprietor: SGS-THOMSON MICROELECTRONICS, INC., Carrollton Texas 75006 (US)
(72) Inventor: Chen, Fusen E., Milpitas, California 95035 (US); Liou, Fu-Tai, Carrollton, Texas 75010 (US); Dixit, Girish A., Dallas, Texas 75287 (US); Wei, Che-Chia, Plano, Texas 75093 (US)
(74) Representative: Palmer, Roger

(56) References cited:
- EP-A- 0 257 277
- EP-A- 0 451 571
- PATENT ABSTRACTS OF JAPAN vol. 010, no. 082 (E-392)2 April 1986 & JP-A-60 227 446

## Description

The present invention relates generally to semiconductor integrated circuits, and more specifically to a method for depositing metal layers in integrated circuits so as to form an improved interlevel contact.

This application is related to European Patent Application No 91310146.5 (EP-A-0 485 130) the contents of which are incorporated herein by this cross reference.

In semiconductor integrated circuits, formation of metal interconnect layers is important to the proper operation of these devices. Metal interconnect signal lines make contact to lower conductive layers of the integrated circuit through vias in an insulating layer. For best operation of the device, the metal used to form the interconnect layer should completely fill the via.

Because of its physical properties, aluminum is especially suited for fabrication of metal interconnect lines in integrated circuits. However, the sputtering process used to apply aluminum thin film layers to an integrated circuit generally results in less than ideal filling of contact vias. Large aluminum grains tend to form on the upper surface of the insulating layer. Those grains which form at the edges of the contact via tend to block it before aluminum has a chance to completely fill the via. This results in voids and uneven structures within the via.

This problem is especially acute as integrated circuit devices are fabricated using smaller geometries. The smaller contacts used in these devices tend to have a larger aspect ratio (height to width ratio) than larger geometry devices, which exacerbates the aluminum filling problem.

The uneven thickness of the aluminum layer going into the via, caused by the step coverage problem just described, has an adverse impact on device functionality. If the voids in the via are large enough, contact resistance can be significantly higher than desired. In addition, the thinner regions of the aluminum layer will be subject the well known electromigration problem. This can cause eventual open circuits at the contacts and failure of the device.

Many approaches have been used to try to ensure good metal contact to lower interconnect levels. For example, refractory metal layers have been used in conjunction with the aluminum interconnect layer to improve conduction through a via. Sloped via sidewalls have been used to improve metal filling in the via. The use of sloped sidewalls is becoming less common as device sizes shrink because they consume too much area on a chip.

One technique which has been proposed to overcome the via filling problem is to deposit the aluminum interconnect layers at a temperature between 500°C and 550°C. At these temperatures, the liquidity of the aluminium is increased, allowing it to flow down into the vias and fill them. This technique is described, for example, in DEVELOPMENT OF A PLANARIZED Al-Si CONTACT FILLING TECHNOLOGY, H. Ono et al, June 1990 VMIC Conference proceedings, pages 76-82. This references teaches that temperatures below 500°C and above 550°C result in degraded metal filling of contact vias. It is believed that use of such technique still suffers from problems caused by large grain sizes.

Even with these techniques, the problems of completely filling a via with aluminum are not solved. In part this is due to the fact that aluminum is deposited at a low rate, which tends to encourage larger grain sizes. Voids and other irregularities within the contact continue to be problems with current technologies.

It would be desirable to provide a technique for depositing aluminum thin film layers on an integrated circuit so as to improve coverage in contact vias. It is also desirable that this technique provide a smooth aluminum surface which is easily patterned. It is further desirable that such a technique be compatible with current standard process flows.

Therefore, according to the present invention, a method is provided for depositing aluminum thin film layers to form improved quality contacts in a semiconductor integrated circuit device. All or some of the deposition process occurs at relatively low deposition rates at a temperature which allows improved surface migration of the deposited aluminum atoms. Aluminum deposited under these conditions tends to fill contact vias without the formation of voids. In order to improve the surface smoothness of the deposited aluminum, the deposition step is periodically interrupted.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:
**Figures 1** and **2** illustrate the formation of a metallic contact according to the present invention;
**Figure 3** is a graph illustrating preferred process conditions for formation of an aluminum contact;
**Figure 4** illustrates several alternative deposition rate diagrams for forming contacts according to the present invention; and
**Figure 5** is a deposition rate diagram illustrating an improved alternative deposition process.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

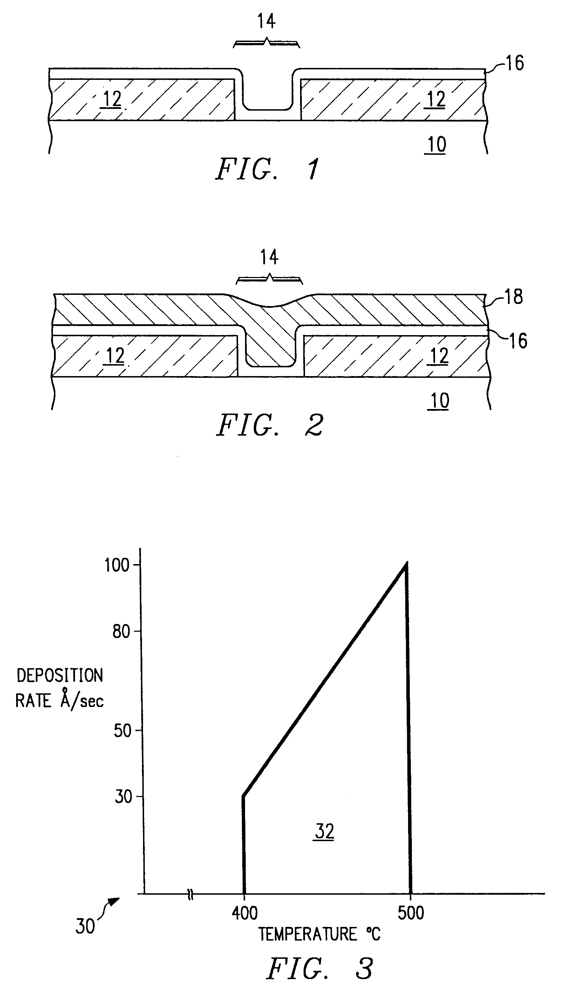

Referring to **Figure 1**, an integrated circuit device is formed in and on a substrate **10**. An insulating layer **12**, such as a a reflow glass or other oxide layer as known in the art, is formed over the substrate **10**. Layer **12** typically has a thickness on the order of approximately 6000-12,000 angstroms. A contact via **14** is formed through the oxide layer **12** using a mask and an isotropic etching technique as known in the art. Via **14** is shown as making contact with substrate **10** in **Figure 1**, but may be formed over a lower interconnect layer as known in the art.

A barrier metal layer **16**, such as a refractory metal, refractory metal nitride, refractory metal silicide, or combination thereof, is deposited over the surface of the device as known in the art. Layer **16** is relatively thin, typically approximately 500-2000 angstroms thick, and is deposited conformally to cover the bottom and sidewalls of contact opening **14**.

Referring to **Figure 2**, an aluminum layer **18** is deposited over the surface of the device. When the aluminum layer **18** is deposited using the process conditions described below, the layer **18** actually completely fills in the via **14** as shown in **Figure 2**. This occurs because the preferred process conditions enhance the surface migration of the deposited aluminum atoms, so that aluminum formation in the bottom of the via **14** occurs preferentially to formation on the oxide layer **12** near the edges of the via **14**. This ensures a high quality, reproducible contact within the via **14**, greatly minimizing the problems caused by incomplete filling of the via **14**.

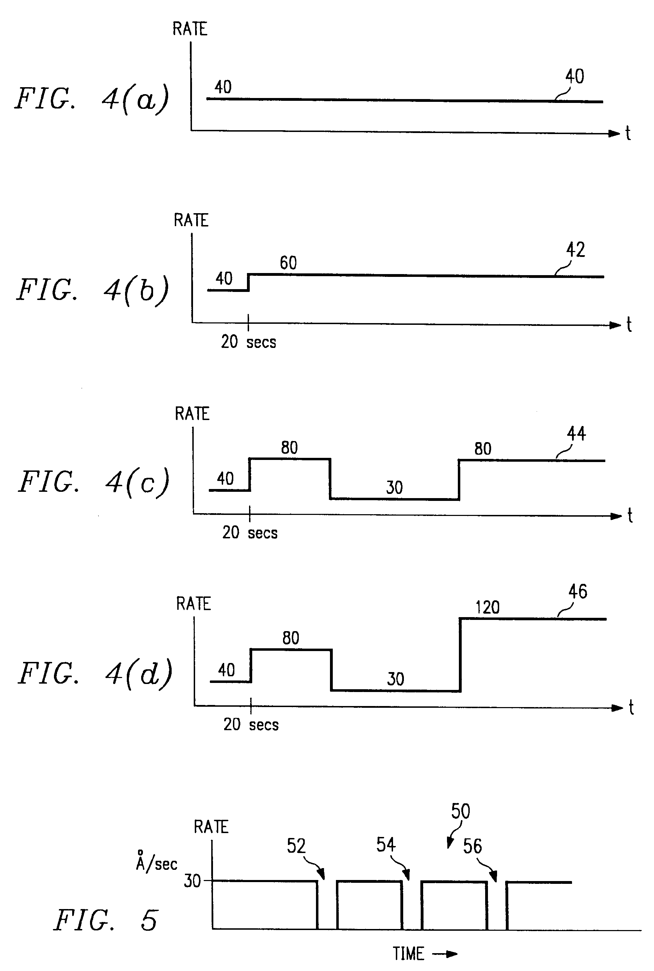

**Figures 3** and **4** illustrate preferred conditions for deposition of the aluminum layer **18** in order to provide an improved contact. Graph **30** illustrates the deposition rate, in angstroms per second, as a function of the deposition temperature in degrees Celsius. The preferred region **32** lies between 400°C-500°C, with the maximum deposition rate lying below a line extending from a rate of about 30 angstroms per second at 400°C to 100 angstroms per second at 500°C.

When aluminum is deposited within this preferred region **32**, its surface migration characteristics are enhanced over metal deposited under other conditions. For example, depositing aluminum at temperatures higher than 500°C tends to form large grains, so that blocking of the contact opening occurs as described earlier. If the deposition rate is too high, the deposited aluminum is not able to migrate quickly enough into the via to completely fill it. Therefore, the region **32** depicted in **Figure 3** outlines, approximately, a preferred pairing of processing conditions under which deposited aluminum migrates into the contact via and fills it while minimizing the formation of voids and uneven regions.

Process conditions can be varied slightly from that shown in **Figure 3** without departing from the teachings of the present invention. For example, temperatures a little below 400°C can be used, as long as the deposition rates are not too high. As the temperature decreases, the mobility of the deposited aluminum atoms goes down, so that incomplete filling of the via occurs if the deposition rates are too high.

**Figure 4** includes four graphs illustrating preferred processes by which an aluminum interconnect layer can be formed. All of these processes utilize, to a greater or lesser degree, processing which occurs within the preferred region **32**. Each of the curves **40**, **42, 44, 46** illustrates a variation in the aluminum deposition rate with time. Each curve **40-46** illustrates an alternative process utilizing the concepts of the present invention.

Each of the four processes shown in **Figure 4** preferably uses approximately the same set of initial conditions. In the prior art, it is common to deposit a very thin layer of small grain aluminum at a relatively cold temperature, typically below 350°C, and then stop the deposition process. The wafer on which the integrated circuit device is located is then preheated to the required deposition temperature, over 500°C, by bathing the wafer with a stream of preheated argon gas. Once the wafer has reached the deposition temperature, deposition of the aluminum is resumed at such elevated temperature.

In the present technique, aluminum is preferably deposited on the device continuously while the device is being heated. Thus, a small amount of aluminum is deposited on the device while the wafer is at or below 350°C. As the wafer gradually heats to the desired deposition temperature, aluminum deposition continues. This gives a layer of aluminum which is deposited with very small grain sizes, tending to minimize grain size growth at later stages. The deposition temperature is between 400°C and 500°C, and is typically reached in about 40 seconds.

**Figure 4** shows deposition rate curves for four alternative deposition techniques. For all of the curves in **Figure 4**, the initial temperature of the wafer is assumed to be approximately 350°C, with the final deposition temperature being 450°C. Heating the wafer to 450°C takes approximately 40 seconds. It will be appreciated by those skilled in the art that different deposition temperatures may be used. Once the wafer has heated to the deposition temperature, the temperature remains constant.

Curve **40** in **Figure 4(a)** depicts a deposition process in which the deposition rate stays constant during the entire course of depositing the aluminum layer **18**. Deposition begins when heat is first applied to the wafer in the chamber, and continues while the wafer heats to 450°C and remains there. At a rate of 40 angstroms per second, an 8000 angstrom thick aluminum layer will take approximately 200 seconds to deposit.

**Figure 4(b)** shows an alternative deposition process in which the deposition rate is performed at 40 angstroms per second for the first 20 seconds, and 60 angstroms per second thereafter. The temperature is increasing toward the 450°C point during the entire deposition step at 40 angstroms per second, and for the first 20 seconds at 60 angstroms per second. For an 8000 angstrom layer, the process curve **42** will result in an aluminum layer formation process which takes approximately 140 seconds.

Curve **44** shows a process in which the initial deposition rate is 40 angstroms per second, followed by an increase to 80 angstroms per second after 20 seconds. After approximately one-third of the entire thickness of the aluminum layer has been deposited, the deposition rate is changed to 30 angstroms per second. This rate is maintained for the deposition of approximately another one-third of the entire layer thickness, followed by an increase of the deposition rate back to 80 angstroms per second.

The process depicted by curve **44** will take approximately 160 seconds to deposit an 8000 angstrom layer of aluminum. This assumes that 2400 angstroms are deposited during each of the 80 angstrom per second segments, and during the 30 angstrom per second segment. The process of **Figure 4(c)** provides for an initial fast deposition of aluminium, followed by a slow deposition period in which deposited aluminium is given the opportunity to migrate into the contact opening. The 30 angstrom deposition period will last for approximately 80 seconds, in order to deposit 2400 angstroms.

Curve **46** in **Figure 4(d)** starts in the same manner as curve **44**, but ends with a higher deposition rate. Processing time is saved by the faster deposition near the end of the process. By this point in the deposition process, the contact opening has been mostly filled, and the possibility of voiding in the via has been greatly decreased. Thus, there is no harm to depositing aluminum at a rate which falls outside of the preferred region **32**.

It will be appreciated by those skilled in the art that the processes shown in **Figure 4** are illustrative and not definitive. Other variations are possible. The precise combination of deposition temperatures and deposition rates can be varied to suit the requirements and restrictions of the particular processes at hand. For example, if large contact openings only are used, faster deposition rates can be made as the voiding problem is not so critical. For processes such as those illustrated by curves **44** and **46**, it is not necessary to adhere to a one-third thickness deposition at each rate. These rates and times may be varied to suit the requirements of a production process while still taking advantage of the concepts of the invention.

It is also possible to use the technique of depositing aluminum within the preferred area **32** without continuously depositing aluminum while the wafer temperature is ramping up to the deposition temperature. As is done on the prior art, a thin layer of aluminum can be deposited at relatively cold temperatures, preferably below 350°C. Deposition is then stopped while the wafer is brought to a temperature between 400°C and 500°C. Deposition is then resumed at a rate within the preferred region **32**, and completed using the teachings set forth above. For example, any of the curves in **Figure 4** can be used, with the difference that the initial 40 angstroms per second deposition rate is omitted.

Referring to **Figure 5**, curve **50** illustrates an improved alternative process for depositing aluminum in accordance with the principles set forth above. It has been found that the process as described above provides excellent filling characteristics, with improved characteristics coming at lower deposition rates. However, very low deposition rates cause a somewhat roughened upper surface of the deposited aluminum layer. This roughened surface causes difficulty in patterning the deposited aluminum layer, due both to line width control problems caused by scattering and uneven etch rates.

It has been found that the deposition process illustrated by curve **50** in **Figure 5** provides the excellent coverage described above, and further results in a smooth surface on the deposited aluminum layer. Curve **50** provides for stopping deposition completely during selected intervals **52, 54, 56**. As shown in **Figure 5**, aluminum is otherwise deposited at a constant rate of 30 angstroms per second.

It is believed that periodically ceasing aluminum deposition entirely allows for some crystal growth to occur in the deposited aluminum layer, which tends to smooth out the upper surface of the final layer. As known in the art, a smoother metal surface allows easier and more accurate patterning of the deposited metal film.

Although **Figure 5** shows a deposition rate of 30 angstroms per second, other rates may be used. For example, a deposition rate of 50 or 60 angstroms per second can be utilized with the interrupted deposition concept described herein. In addition, variable deposition rates of the type described in connection with **Figure 4** may also be used, with the simple insertion of intervals **52 - 56** in which deposition is stopped entirely.

The number of intervals **52 - 56** which are used is not critical, although at least two intervals are preferably used. Each of the intervals **52 - 56** preferably has a duration of at least 20 seconds. The number of intervals used, and their duration, will need to be varied with the deposition rate and thickness of the deposited aluminum film. Thicker films will tend to require more and longer interruption intervals **52 -** **56** in order to obtain a given smoothness of the final metal layer. As an example, one technique which gives good results uses five deposition interruption intervals of 60 seconds each.

In summary, by providing periodic stops during aluminum deposition as described above the smoothness of the resulting aluminum film can be improved. This makes later patterning of the aluminum easier while maintaining the excellent filling characteristics of the described process conditions.

## Claims

1. A method for forming an aluminum contact in an integrated circuit, comprising the steps of:
forming an insulating layer (12) over a conducting layer (10);
forming an opening (14) through the insulating layer (12) to expose a portion of the conducting layer (10);
raising the temperature of the integrated circuit from below approximately 350°C to a value between approximately 400°C and approximately 500°C; and
during said step of raising the temperature, beginning to deposit aluminum (18) over the insulating layer (12) and in the opening (14) at a temperature of between approximately 400°C and approximately 500°C;
after said step of raising the temperature, continuing said step of depositing aluminum;
during said depositing step, controlling the rate at which aluminum (18) is deposited to allow the deposited aluminum (18) to migrate into the opening (14) so as to provide a substantially complete fill thereof; and
periodically interrupting said depositing step for selected time periods.

2. The method of Claim 1, wherein said depositing step comprises depositing aluminum (18) at a constant rate.

3. The method of Claim 1, wherein said depositing step comprises depositing aluminum (18) at a rate which changes over time.

4. The method of Claim 1, wherein said interrupting step comprises the steps of:
stopping deposition of the aluminum (18);
maintaining the temperature of the integrated circuit;
at the end of a first selected time period, resuming aluminum deposition; and
repeating said stopping, maintaining and resuming steps.

5. The method of Claim 4, wherein said stopping, maintaining and resuming steps are performed more than twice during said depositing step.

6. The method of Claim 5, wherein said stopping, maintaining and resuming steps are performed at least five times during said depositing step.

7. A method of Claim 4, wherein the selected time periods each have a duration of at least 20 seconds.

8. A method of Claim 4, wherein the selected time periods each have a duration of at least 60 seconds.

9. The method of Claim 4, wherein each said selected time period has the same duration.

10. The method of Claim 1, wherein said controlling step comprises the step of:
maintaining the deposition rate to be less than approximately
(.7 * T) - 25 nanometres/sec
where T lies between approximately 400°C and 500°C.

11. The method of claim 1, wherein said step of beginning to deposit aluminum begins approximately simultaneously with said step of raising the temperature.

## Patentansprüche

1. Verfahren zur Ausbildung eines Aluminiumkontakts in einer integrierten Schaltung, das folgende Schritte aufweist:
eine Isolierschicht (12) wird über einer leitenden Schicht (10) ausgebildet;
eine Öffnung (14) wird durch die isolierende Schicht (12) hindurch ausgebildet, um einen Abschnitt der leitenden Schicht (10) freizulegen;
die Temperatur der integrierten Schaltung wird von unterhalb näherungsweise 350°C auf einen Wert zwischen näherungsweise 400°C und näherungsweise 500°C angehoben; und
während des Schritts des Anhebens der Temperatur, wird mit dem Abscheiden des Aluminiums (18) über der isolierenden Schicht (12) und in der Öffnung (14) bei einer Temperatur von zwischen näherungsweise 400°C und näherungsweise 500°C begonnen;
nach dem Schritt der Erhöhung der Temperatur wird der Schritt des Abscheidens des Aluminiums fortgesetzt;
während des Abscheideschritts wird die Rate gesteuert, bei der das Aluminium (18) abgeschieden wird, um es dem abgeschiedenen Aluminium (18) zu ermöglichen, in die Öffnung (14) zu wandern, um so eine im wesentlichen vollständige Füllung derselben zu ermöglichen; und
der Abscheideschritt wird periodisch für ausgewählte Zeitabschnitte unterbrochen;

2. Verfahren nach Anspruch 1, bei welchem der Abscheideschritt das Abscheiden des Aluminiums (18) bei konstanter Rate umfaßt.

3. Verfahren nach Anspruch 1, bei welchem der Abscheideschritt das Abscheiden von Aluminium (18) bei einer Rate umfaßt, die sich mit der Zeit ändert.

4. Verfahren nach Anspruch 1, bei dem der Unterbrechungsschritt weiter folgende Schritte aufweist:
die Abscheidung von Aluminium (18) wird angehalten;
die Temperatur der integrierten Schaltung wird aufrechterhalten;
am Ende des ersten gewählten Zeitabschnittes wird die Aluminiumabscheidung wieder aufgenommen; und
die Schritte des Anhaltens, Aufrechterhaltens und Wiederaufnehmens werden wiederholt.

5. Verfahren nach Anspruch 4, bei welchem die Schritte des Anhaltens, Aufrechterhaltens und Wiederaufnehmens mehr als zweimal während des Abscheideschritts durchgeführt werden.

6. Verfahren nach Anspruch 5, bei welchem die Schritte des Anhaltens, Aufrechterhaltens und Wiederaufnehmens wenigstens fünf mal während dem Abscheideschritt durchgeführt werden.

7. Verfahren nach Anspruch 4, bei welchem die gewählten Zeitabschnitte jeweils eine Dauer von wenigstens 20 Sekunden aufweisen.

8. Verfahren nach Anspruch 4, bei welchem die gewählten Zeitabschnitte jeweils ein Dauer von wenigstens 60 Sekunden aufweisen.

9. Verfahren nach Anspruch 4, bei welchem jeder der gewählten Zeitabschnitte dieselbe Dauer aufweist.

10. Verfahren nach Anspruch 1, bei welchem der Steuerschritt den folgenden Schritt aufweist:
die Depositionsrate bzw. Abscheiderate wird bei weniger als näherungsweise
(0,7 * T) - 25 nm/s
aufrechterhalten, wobei T zwischen näherungsweise 400°C und 500°C liegt.

11. Verfahren nach Anspruch 1, bei welchem der Schritt des Beginnens mit der Abscheidung von Aluminium näherungsweise gleichzeitig mit dem Schritt der Temperaturerhöhung beginnt.

## Revendications

1. Procédé de fabrication d'un contact en aluminium dans un circuit intégré, comprenant les étapes suivantes :
- on forme une couche isolante (12) sur une couche conductrice (10) ;
- on forme une ouverture (14) au travers de la couche isolante (12) afin d'exposer une partie de la couche conductrice (10) ;
- on augmente la température du circuit intégré, depuis une valeur inférieure à approximativement 350 °C jusqu'à une valeur située entre approximativement 400 °C et approximativement 500 °C ; et
- pendant ladite étape d'augmentation de la température, on commence à déposer de l'aluminium (18) sur la couche isolante (12) et dans l'ouverture (14), à une température située entre approximativement 400 °C et approximativement 500 °C ;
- après ladite étape d'augmentation de la température, on poursuit ladite étape de dépôt d'aluminium ;
- pendant ladite étape de dépôt, on commande la vitesse à laquelle l'aluminium (18) est déposé, afin de permettre à l'aluminium déposé (18) de pénétrer dans l'ouverture (14) afin de remplir sensiblement complètement celle-ci ; et
- on interrompt périodiquement ladite étape de dépôt pour des périodes de temps sélectionnées.

2. Procédé selon la revendication 1, dans lequel ladite étape de dépôt comprend le dépôt d'aluminium (18) à une vitesse constante.

3. Procédé selon la revendication 1, dans lequel ladite étape de dépôt comprend le dépôt d'aluminium (18) à une vitesse qui change avec le temps.

4. Procédé selon la revendication 1, dans lequel ladite étape d'interruption comprend les étapes suivantes :
- on arrête le dépôt de l'aluminium (18) ;
- on maintient la température du circuit intégré ;
- à la fin d'une première période de temps sélectionnée, on reprend l'opération de dépôt d'aluminium ; et
- on répéte lesdites étapes d'arrêt, de maintien et de reprise.

5. Procédé selon la revendication 4, dans lequel lesdites étapes d'arrêt, de maintien et de reprise sont exécutées plus de deux fois au cours de ladite étape de dépôt.

6. Procédé selon la revendication 5, dans lequel lesdites étapes d'arrêt, de maintien et de reprise sont exécutées au moins cinq fois au cours de ladite étape de dépôt.

7. Procédé selon la revendication 4, dans lequel les périodes de temps sélectionnées ont chacune une durée d'au moins 20 secondes.

8. Procédé selon la revendication 4, dans lequel les périodes de temps sélectionnées ont chacune une durée d'au moins 60 secondes.

9. Procédé selon la revendication 4, dans lequel chacune desdites périodes de temps sélectionnées a la même durée.

10. Procédé selon la revendication 1, dans lequel ladite étape de commande comprend l'étape suivante :
on maintient la vitesse de dépôt à une valeur inférieure à approximativement
(0,7 * T) - 25 nanomètres/sec
où T est compris entre approximativement 400 °C et 500 °C.

11. Procédé selon la revendication 1, dans lequel ladite étape de commencement du dépôt d'aluminium débute approximativement en même temps que ladite étape d'augmentation de la température.
